(19) Europäisches Patentamt

European Patent Office

Office européen des brevets

(11) Veröffentlichungsnummer: **0 229 936**
**B1**

(12) **EUROPÄISCHE PATENTSCHRIFT**

(45) Veröffentlichungstag der Patentschrift: **10.10.90**

(21) Anmeldenummer: **86116541.3**

(22) Anmeldetag: **28.11.86**

(51) Int. Cl.⁵: **B 32 B 15/04,** C 22 C 29/16,
C 22 C 29/00, C 23 C 14/48,
C 23 C 16/26, C 23 C 16/34,
B 23 B 27/14

(54) Hartstoffschichten für mechanisch und korrosiv beanspruchte Teile.

(30) Priorität: **17.12.85 DD 284407**

(43) Veröffentlichungstag der Anmeldung:
**29.07.87 Patentblatt 87/31**

(45) Bekanntmachung des Hinweises auf die
Patenterteilung:
**10.10.90 Patentblatt 90/41**

(84) Benannte Vertragsstaaten:
**CH DE FR GB IT LI NL SE**

(56) Entgegenhaltungen:
**DD-A-1 227 456**
**DD-A-1 227 457**
**DE-A-13 421 739**
**GB-A-2 156 387**

**PATENT ABSTRACTS OF JAPAN, unexamined
applications, Feld C, Band 10, Nr. 17, 23. Januar
1986. THE PATENT OFFICE JAPANESE
GOVERNMENT Seite 11 C 324.**

(73) Patentinhaber: **Technische Universität Karl-
Marx-Stadt
Postfach 964
DDR-9010 Karl-Marx-Stadt (DD)**

(72) Erfinder: **Weissmantel, Christian, Prof. Dr. rer.
nat. habil.
Waldstrasse 5
Karl-Marx-Stadt 9033 (DD)**
Erfinder: **Rau, Bernd, Dr. rer. nat.
Dimitroffstrasse 38
Karl-Marx-Stadt 9072 (DD)**
Erfinder: **Bewilogua, Klaus, Dr. sc. nat.
Alfred-Neubert-Strasse 32
Karl-Marx-Stadt 9051 (DD)**
Erfinder: **Roth, Dietmar, Dr. rer. nat.
Am Hang 23 e
Wüstenbrand 9274 (DD)**
Erfinder: **Rother, Bernd, Dr. rer. nat.
Am Harthwald 14
Karl-Marx-Stadt 9051 (DD)**

(74) Vertreter: **Hoffmann, Klaus, Dr. rer. nat. et al
Hoffmann . Eitle & Partner Patentanwälte
Postfach 81 04 20 Arabellastrasse 4
D-8000 München 81 (DE)**

**EP  0 229 936  B1**

(56) Entgegenhaltungen:

PATENT ABSTRACTS OF JAPAN, unexamined applications, Feld C, Band 7, Nr. 19, 25. Januar 1983. THE PATENT OFFICE JAPANESE GOVERNMENT Seite 60 C 147.

**Beschreibung**

Die Erfindung betrifft eine Hartstoffschicht auf der Grundlage von Kohlenstoff oder Bornitrid, die auf einen mechanisch und korrosiv beanspruchten Substratwerkstoff oder auf eine mechanisch und korrosiv belastete Baugruppe aufgebracht ist.

Derartige Hartstoffschichten erhöhen die Lebensdauer und verbessern die Funktionseigenschaften damit beschichteter Teile, welche Werkzeuge, Werkzeugeinsätze, Lager oder korrosiv belastete Baugruppen sein können. Eine weitere Anwendung erfolgt in der Elektronik und Optik sowie zu dekorativen Zwecken.

Hartstoffschichten für mechanisch und korrosiv beanspruchte Teile sind in vielen Fällen ionengestützt abgeschiedene Schichten, die in Abhängigkeit vom Verwendungszweck in verschiedenen Varianten bekannt sind.

In der DE—A—34 21 739 wird ein Herstellungsverfahren für diamantartige Kohlenstoff- bzw. Kohlenwasserstoff-Schichten beschrieben. Diese Schichten finden vorwiegend für die Vergütung optischer Bauteile Verwendung. Zweckentsprechend werden dünne transparente Schichten (<0,5 μm) hoher Härte beschrieben. Es ist bekannt, daß derartige Schichten bei größeren Dicken nicht mehr haftfest abscheidbar sind. Außerdem ist der Anwendungsbereich derartiger Schichten stark eingeschränkt.

In der DD—PS 155 826 werden Hartstoffschichten beschrieben, die aus diamantähnlichem Kohlenstoff, Metall und Karbiden, Nitriden, Boriden usw. bestehen. Die Verbindungsbildung von Karbiden, Nitriden usw. erfordert hohe Bildungsenergien bzw. -temperaturen auch beim Einsatz ionengestützter Beschichtungsverfahren, so daß noch unbeschichtete, thermisch empfindliche Teile nicht oder nur mit erhöhtem apparativen Aufwand beschichtbar sind. So liegen z.B. die Bildungstemperaturen für Niedertemperatureisenkarbidphasen oberhalt 300°C und für Chromiumkarbid oberhalb 1000°C (K. Bewiloga u.a., Kristall und Technik, 15 (1980), 1205).

Die DE—A—3 246 361 offenbart eine Gleitschicht, bestehend aus einer Kohlenstoff-Metall-Matrix. Eine Schicht, die den Anforderungen guter Gleiteigenschaften entspricht, kommt entsprechend diesem Aufbau jedoch den Forderungen nach einem Korrosions- und Verschleißschutz nicht nach.

Des weiteren sind aus der DD—PS 156 717 Hartstoffschichten auf der Basis von Bornitrid bekannt. Die Haftung derartiger Schichten besonders auf metallischen Substraten ist ungenügend und muß durch Zwischenschichten verbessert werden. Der beschriebene Dickenbereich von 0,2—3 μm weist eine verschleißmindernde Wirkung nur bei geringen Normalkräften während des Verschleißprozesses auf.

Die beschriebenen Hartstoffschichten sind nur für begrenzte Anwendungsgebiete einsetzbar, wobei sie in der Regel nur einer speziellen Anforderung, z.B. Verschleiß oder Korrosion, angepaßt sind.

Der Erfindung liegt die Aufgabe zugrunde, eine Hartstoffschicht für mechanisch und korrosiv beanspruchte Teile auf der Basis von Kohlenstoff oder Bornitrid zu schaffen, die auf beliebige, bei der Beschichtung nicht extern aufgeheizte Substratwerkstoffe aufgebracht wird, eine große Härte sowie eine vollständige Haftung bei guten Korrosions- sowie Verschleißschutzeigenschaften besitzt und eine hohe Temperaturbeständigkeit während der Belastung aufweist.

Erfindungsgemäß wird die Aufgabe dadurch gelöst, daß eine Kohlenstoff- oder Bornitridschicht eine amorphe Netzwerkstruktur mit einer atomaren Nahordung aufweist, die der in den hexagonalen kristallinen Phasen ähnlich ist, einen Wasserstoffanteil von 5 Atom% bis 50 Atom% besitzt und eine Schichtkomponente, bestehend aus Metall und/oder Bor und/oder Silicium und/oder Edelgasen im Bereich von 1 Atom% bis 85 Atom%, vorhanden ist.

Es hat sich im Rahmen der erfindungsgemäßen Lösung als vorteilhaft gezeigt, daß insbesondere das Zusammenwirken der atomaren Nahordnung, die der in den hexagonalen kristallinen Phasen ähnlich ist, mit dem Vorhandensein von Wasserstoff zu mechanischen Schichteigenschaften führt, die mit bekannten Schichtstrukturen und -zusammensetzungen nicht erreicht werden können. Durch den Einbau der Schichtkomponente werden die Schichteigenschaften entsprechend den Anwendungsgebieten angepaßt und verbessert.

Die Hartstoffschicht befindet sich erfindungsgemäß auf beliebigen Unterlagen, wie Hartmetall, Schnellarbeitstahl, Aluminium, Silicium, Kupfer, Messing, Bronze, Zink, Keramik oder Kochsalz. Um die Haftung der Harnstoffschicht besonders bei Kupfer, Messing und Bronze zu gewährleisten, ist in einer Ausgestaltung der Erfindung eine Zwischenschicht aus Titannitrid oder Aluminium vorhanden.

Eine Hartstoffschicht nach der Erfindung wird in einer vorzugsweisen Ausgestaltung mittels ionengestützter Beschichtungsverfahren bei Ionenenergien von 50 eV bis 10 000 eV aufgebracht, wobei die eingelagerten Schichtkomponente in Form von Molekülen und/oder Clustern vorliegen. Die Schichtdicke liegt erfindungsgemäß zwischen 0,01 μm und 20 μm.

Nach einer Ausführungsform der Erfindung verändert sich der Anteil der einzelnen Schichtbestandteile innerhalb der Schichtdicke kontinuierlich oder sprunghaft.

Es ist im Sinne der Erfindung, daß die Härte der beschriebenen Hartstoffschicht zwischen 10 GPa und 60 GPa in Abhängigkeit vom Schichtaufbau, Substrat und Anwendungsliegt.

Bei einer Hartstoffschicht auf Kohlenstoffbasis erfolgt vorteilhafterweise die Anpassung im wesentlichen durch die Veränderung des Vernetzungsgrades des Kohlenstoff-Netzwerkes. Der gezielte Wasserstoffeinbau führt zur Absättigung freier Bindungen des Netzwerkes und damit zu einer notwendigen Stabilisierung.

Eine ähnliche Rolle spielen die eingelagerten Schichtkomponenten im Bornitrid-Netzwerk, die zu einer Verringerung der inneren Spannungen in der Bornitridschicht führen, wodurch eine bessere Haftung auf dem Substratwerkstoff erreicht wird. Schichtkomponenten in Form von Metallen, Metallnitriden und/oder Metallcarbiden mit ihren bekannten Wirkungen als Katalysatoren für die Bildung des kubischen Bornitrids finden in der erfindungsgemäßen Lösung eine eingepaßte Verwendung.

Die Erfindung soll anhand von Ausführungsbeispielen näher erläutert werden.

Eine Hartstoffschicht befindet sich auf einem gereinigten Hartmetallsubstrat mit einer Vikershärte $VH_{0,04} \approx 16$ GPa. Die Schicht wird mittels ionengestützter Abscheideverfahren mit Benzen als Kohlenstoffträger auf gekühltem Substrat abgeschieden. Die Ionenenergie betrug dabei 1000 eV. Die Hartstoffschicht mit einer Dicke von 5,0 µm setzt sich aus 60 Atom% Kohlenstoff, 20 Atom% Chromium und 20 Atom% Wasserstoff zusammen.

Durch Verwendung der Metallkomponente Chromium wird in diesem Fall eine besonders hohe zusätzliche Korrosionsschutzwirkung erzielt. Es wird ausgenutzt, daß Chromium/Kohlenstoff-Schichten eine große Neigung zur Passivierung und eine hohe Beständigkeit im passiven Zustand besitzen.

Das Korrosionsverhalten von Chrom-Kohlenstoffschichten umfaßt in Abhängigkeit von der Zusammensetzung der Schicht des Korrosionsverhalten des Chromiums und die chemische Resistenz des Kohlenstoffe.

Die Grenzflächenenergie (Haftenergie) beträgt $2,5 . 10^{-2}$ N $cm^{-1}$, Dichte=3,0 g $cm^{-3}$. Die Schicht weist einen Reibkoeffizienten $\mu \approx 0,15$ und eine Vickershärte $VH_{0,04} \geq 25$ GPa auf.

2. Ein poliertes und vor der Beschichtung entfettetes Bronzesubstrat ist mit einer Hartstoffschicht aus Korrosions- und Verschleißschutz versehen. Die Schicht ist wie folgt aufgebaut:

Auf dem Substratwerkstoff aus Bronze befindet sich eine haftfeste Aluminium-Zwischenschicht von 100 nm, die ca. 1 Atom% Krypton enthält. Dieser Aluminium-Zwischenschicht folgt ein Schichtbereich von 100 nm Dicke mit einem linearen Aluminium-Gradienten, wobei dieser Schichtbereich am Ende aus 60 Atom% Kohlenstoff, 30 Atom% Aluminium und 10 Atom% Wasserstoff besteht. Dieses Verhältnis der Schichtkomponenten ist bis zu einer Gesamtschichtdicke von 1,0 µm konstant. Im Schichtbereich von 1,0 µm bis 1,2 µm wird die Aluminiumkomponente linear bis auf 5 Atom% gesenkt. Bis zur Gesamtschichtdicke von 4,0 µm besteht die Schicht aus Kohlenstoff mit Netzwerkstruktur, in der 20 Atom% Wasserstoff und 5 Atom% Aluminium enthalten sind.

Die Schicht besitzt eine Härte $VH_{0,04} \geq 20$ GPa und ist im Gegensatz zu reinen Kohlenstoffschichten auch unter Belastung (Auflagedruck bei Verschleißprüfung 1 GPa) haftfest. Der Reibkoeffizient $\mu$ beträgt 0,1. Im Korrosionstest weisen diese Schichten Ruhepotentiale auf, die in der elektrochemischen Spannungsreihe den Potentialen der Edelmetalle entsprechen.

3. Auf einer Hartmetallwendeschneidplatte mit einer Titannitrid-Deckschicht wird eine weitere Hartstoffschicht abgeschieden.

Mittels getrennter Bor- und Titan-Verdampfung und unter Verwendung eines Gasgemisches, bestehend aus 60 Atom% Ammoniak und 40 Atom% Ar, wird bei einer Ionenenergie von 2 keV eine Hartstoffschicht, bestehend aus 85 Atom% Bor, 5 Atom% Titan, 5 Atom% Wasserstoff und 5 Atom% Stickstoff aufgebracht. Diese Schicht is bis 1100°C temperaturbeständig, besitzt eine Härte von $VH_{0,1}=25$ GPa und eine Dichte=2,3 g $cm^{-3}$. Es wurden Haftenergien

$$3,0 . 10^{-2} \; Ncm^{-1} \; gemessen.$$

Der spezifische elektrische Widerstand beträgt $10^{11}\Omega . cm$.

Der strukturelle Aufbau und die chemische Zusammensetzung der beschriebenen Hartstoffschichten sind mittels Elektronenmikroskopie und -beugung, elektronenstrahlinduzierter Analyseverfahren sowie einer Kernreaktionsmethode zur Wasserstoffbestimmung nachzuweisen.

**Patentansprüche**

1. Hartstoffschicht auf der Grundlage von Kohlenstoff oder Bornitrid, die auf einen mechanisch und korrosiv beanspruchten Substratwerkstoff oder auf eine mechanisch und korrosiv belastete Baugruppe aufgebracht ist, dadurch gekennzeichnet, daß eine Kohlenstoff- oder Bornitrid-Schicht einer amorphe Netzwerkstruktur mit einer atomaren Nahordnung, die der in den hexagonalen kristallinen Phasen ähnlich ist, aufweist, in der ein Wasserstoffanteil von 5 Atom% bis 50 Atom% und eine Schichtkomponente, bestehend aus Metallen und/oder Bor und/oder Silicium und/oder Edelgasen im Berich von 1 Atom% bis 85 Atom% vorhanden ist.

2. Hartstoffschicht nach Patentanspruch 1, dadurch gekennzeichnet, daß der Substratwerkstoff aus Hartmetall, Schnellarbeitsstahl, Aluminium, Silicium, Kupfer, Messing, Bronze, Zink, Keramik oder Kochsalz besteht.

3. Hartstoffschicht nach Patentanspruch 1 und 2, dadurch gekennzeichnet, daß eine Zwischenschicht aus Titannitrid oder Aluminium vorhanden ist.

4. Harstoffschicht nach den Patentansprüchen 1 bis 3, dadurch gekennzeichnet, daß die Hartstoffschicht mittels ionengestützter Beschichtungsverfahren bei Ionenenergien von 50 eV bis 10 000 eV aufgebracht ist.

5. Hartstoffschicht nach den Patentansprüchen 1 bis 4, dadurch gekennzeichnet, daß die eingelagerte Schichtkomponente in Form von Molekülen und/oder Clustern vorhanden ist.

6. Hartstoffschicht nach den Patentansprüchen 1 bis 5, dadurch gekennzeichnet, daß der Anteil der einzelnen Schichtkomponenten sich innerhalb der Schichtdicke kontinuierlich oder sprunghaft verändert.

7. Hartstoffschicht, nach den Patentansprüchen 1 bis 6, dadurch gekennzeichnet, daß die Schichtdicke zwischen 0,01 µm und 20 µm liegt.

8. Hartstoffschicht nach den Patentansprüchen 1 bis 7, dadurch gekennzeichnet, daß die Schicht eine Härte von 10 GPa bis 60 GPa besitzt.

**Revendications**

1. Couche de matière dure à base de carbone ou de nitrure de bore appliquée sur un matériau de support exposé à des contraintes mécaniques et à la corrosion ou sur structure exposée à des contraintes mécaniques et à la corrosion, caractérisée en ce qu'une couche de carbone ou de nitrure de bore présente une structure réticulaire amorphe avec ordre atomique proche analogue à celui des phases cristallines hexagonales, contient de 5 atomes% à 50 atomes% d'hydrogène et un composant consistant en métaux et/ou bore et/ou silicium et/ou gaz rares en proportions dans l'intervalle de 1 atome% à 85 atomes%.

2. Couche de matière dure selon la revendication 1, caractérisée en ce que le matériau de support consiste en carbure, acier à travail rapide, aluminium, silicium, cuivre, laiton, bronze, zinc, matière céramique ou chlorure de sodium.

3. Couche de matière dure selon les revendications 1 et 2, caractérisée en ce qu'elle est appliquée sur une couche intermédiaire de nitrure de titane ou d'aluminium.

4. Couche de matière dure selon les revendications 1 à 3, caractérisée en ce que la couche de matière dure est appliquée par des procédés de revêtement ioniques avec des énergies ioniques de 50 eV à 10 000 eV.

5. Couche de matière dure selon les revendications 1 à 4, caractérisée en ce que les composants occlus de la couche sont à l'état de molécules et/ou d'amas.

6. Couche de matière dure selon les revendications 1 à 5, caractérisée en ce que la proportion des divers composants de la couche varie en continu ou par paliers à l'intérieur de cette dernière, sur son épaisseur.

7. Couche de matière dure selon les revendications 1 à 6, caractérisée en ce qu'elle a une épaisseur de 0,01 à 20 µm.

8. Couche de matière dure selon les revendications 1 à 7, caractérisée en ce qu'elle a une dureté de 10 GPa à 60 GPa.

**Claims**

1. A hard coating, based on carbon or boron nitride, which is applied to a substrate material subjected to mechanical and corrosive stress or to a mechanically and corrosively stressed assembly, characterized in that it comprises a carbon or boron nitride layer which has an amorphous network structure having a close-order atomic arrangement similar to that in the hexagonal crystalline phase and contains a hydrogen fraction of 5 atom % to 50 atom % and a component of the layer consisting of metals and/or boron and/or silicon and/or inert gases present in the range of 1 atom % to 85 atom %.

2. A hard coating according to Claim 1, characterized in that the substrate material consists of hard metal, high-speed steel, aluminium, silicon, copper, brass, bronze, zinc, ceramic or common salt.

3. A hard coating according to Claim 1 and 2, characterized in that an intermediate layer of titanium nitride or aluminium is present.

4. A hard coating according to Claims 1 to 3, characterized in that the hard coating is applied by means of an ion-assisted coating process using ion energies of 50 eV to 10,000 eV.

5. A hard coating according to Claims 1 to 4, characterized in that the incorporated layer component is present in the form of molecules and/or clusters.

6. A hard coating according to Claims 1 to 5, characterized in that the proportion of the individual components in the layer changes continuously or discontinuously within the thickness of the layer.

7. A hard coating according to Claims 1 to 6, characterized in that the thickness of the layer is between 0.01 µm and 20 µm.

8. A hard coating according to Claims 1 to 7, characterized in that the layer has a hardness of 10 GPa to 60 GPa.